# EUROPEAN PATENT SPECIFICATION

(11) **EP 4 677 291 B1**
(45) Date of publication and mention of the grant of the patent: **11.11.2026**
(21) Application number: 23710848.5
(22) Date of filing: 09.03.2023
(51) Int. Cl.: F25B 23/00, F25B 40/00

(54) **PUMPED TWO-PHASE COOLING SYSTEM**
ZWEI-PHASEN-KÜHLSYSTEM MIT PUMPE
SYSTÈME DE REFROIDISSEMENT BIPHASÉ POMPÉ

(43) Date of publication of application: 14.01.2026
(73) Proprietor: Hitachi Energy Ltd, 8050 Zürich (CH)
(72) Inventor: LUTZ, Pascal, 5432 Neuenhof (CH); HEINIG, Stefanie, 4053 Basel (CH); SCHWARZMAIER, Thomas, 5430 Wettingen (CH); BAUMANN, Remo, 5600 Lenzburg (CH)
(74) Representative: Vossius & Partner Patentanwälte Rechtsanwälte mbB
(86) International application number: PCT/EP2023/055955
(87) International publication number: WO 2024/183909

(56) References cited:
- US-B1- 6 866 092
- US-B2- 10 436 521
- US-B2- 10 458 665

## Description

### BACKGROUND

The present invention relates to a pumped two-phase cooling system.

A pumped two-phase cooling system utilizes the latent heat of vaporization of a working fluid to remove thermal energy from a component to be cooled.

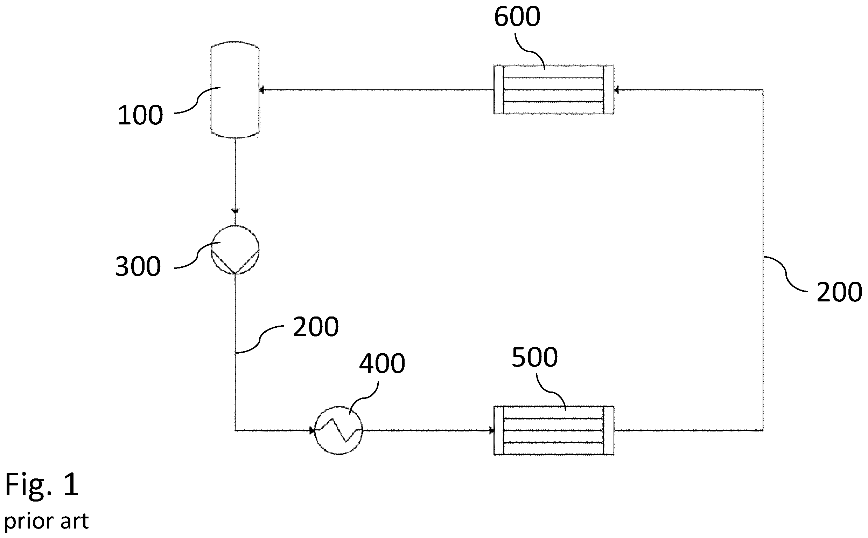

Fig. 1 schematically illustrates a known pumped two-phase cooling system. The system comprises a working fluid circuit 200 for guiding a two-phase working fluid.

The system further comprises a pump 300 for pumping the working fluid through the circuit 200. The system further comprises a preheater 400, an evaporator 500, a condenser 600, and a reservoir 100 also sometimes referred to as an accumulator. The circuit 200 connects these devices 400, 500, 600, 100 to allow the working fluid to flow through the evaporator 500 and subsequently through the condenser 600. The pump 300 pumps the working fluid through the preheater 400, the evaporator 500 and the condenser 600 in that order.

The evaporator 500 is configured to cool a thermal energy dissipating component, for example a power electronic device. To this end, the evaporator 500 is arranged and designed to absorb heat from the respective component to be cooled.

The preheater 400 increases the temperature of the working fluid which enters the preheater 400 in its liquid phase, up to its saturation temperature, i.e. up to its optimal operating point. Accordingly, the working fluid enters the evaporator 500 at least essentially at its saturation temperature. Therefore, the heat or thermal energy absorbed by the working fluid flowing through the evaporator 500 causes the working fluid to partially evaporate. Therefore, the working fluid leaving the evaporator 500 is partly in its liquid phase and partly in its gaseous phase.

Subsequently, the working fluid is guided by the circuit 200 to the condenser 600 where heat is removed from the working fluid so that it is returning to its liquid phase. The condenser 600 disperses the heat to the surrounding environment.

The reservoir 100 is configured to balance the system. To this end, the reservoir 100 stores excess working fluid and compensates for volume changes.

By using the latent heat of the working fluid, it can be achieved that the two-phase cooling system in principle requires less pumping power compared to a single-phase cooling system under otherwise identical conditions.

However, the preheater 400 still requires a certain amount of electric energy to generate a corresponding heat. This leads to a limited efficiency of the system and a limited reliability.

Therefore, there is a need for an improved two-phase cooling system, particularly for a two-phase cooling system having improved features regarding efficiency and reliability.

US 10 458 665 B2 relates to a passive liquid collecting device which has a reservoir with an outlet and one or more rigid structures within the reservoir. The rigid structures are configured to collect a liquid and direct the liquid to the outlet. Porous capillary media are supported by the rigid structures. A thermal control loop is also described. The thermal control loop circulates a refrigerant to remove heat from objects.

US 6 866 092 B1 relates to various techniques for improving airtight two-phase heat-transfer systems employing a fluid to transfer heat from a heat source to a heat sink while circulating around a fluid circuit, the maximum temperature of the heat sink not exceeding the maximum temperature of the heat source. The properties of those improved systems include (a) maintaining, while the systems are inactive, their internal pressure at a pressure above the saturated-vapor pressure of their heat-transfer fluid; and (b) cooling their internal evaporator surfaces with liquid jets.

US 10 436 521 B2 relates to a system which includes a pump, an evaporator, a condenser, an accumulator, a pump bypass line, a first valve, and a second valve. The system may operate in a powered-pump mode, in which the pump drives fluid circulation, the first valve prevents fluid circulation through the pump bypass line, the pump pumps liquid from the accumulator to the evaporator, gas exiting the evaporator flows to the condenser, liquid exiting the evaporator flows through the second valve to the accumulator, and liquid exiting the condenser flows to the accumulator. The system may operate in a passive-capillary mode, in which capillary pressure in the evaporator drives fluid circulation, the first valve prevents fluid circulation through the pump, liquid flows from the accumulator, through the pump bypass line, and to the evaporator, gas exiting the evaporator flows to the condenser, the second valve is closed, and liquid exiting the condenser flows the accumulator.

### SUMMARY

According to the present invention a pumped two-phase cooling system according to claim 1 is provided that comprises a two-phase working fluid circuit. The circuit has a first circuit section for guiding a first portion of the working fluid to a preheater assembly. The first portion in the first circuit section has first thermal characteristics. The circuit further has a second circuit section for guiding a second portion of the working fluid to the preheater assembly. The second portion in the second circuit section has second thermal characteristics. The circuit further comprises a third circuit section for guiding a third portion of the working fluid from the preheater assembly to at least one evaporator. The third portion in the third circuit section has third thermal characteristics based on the first and second thermal characteristics.

By providing for the second circuit section, it is possible to supply additional thermal energy to the working fluid in the first circuit section, i.e. before it enters the evaporator. In this way, it is possible to eliminate the need for a preheater that requires external energy or at least to operate the system using a preheater assembly that requires less energy as compared to a preheater of a cooling system according to the above-mentioned prior art. In other words, the preheater assembly of the cooling system according to the present description may require no or at least less external energy as compared to prior art.

Accordingly, less energy is in principle required to operate the cooling system. Therefore, the two-phase cooling system may show an improved efficiency and consequently, an improved reliability.

Various embodiments may implement the following features:
The preheater assembly may be configured to heat the working fluid to its saturation temperature or at least nearly to its saturation temperature. This is generally advantageous in respect of the cooling capacity of the system. Particularly, the preheater assembly may be configured to heat the working fluid in such a way that its temperature is at or nearly at its saturation temperature when it enters the evaporator.

The term "a temperature nearly to the saturation temperature" is intended to describe a temperature that is within a certain temperature interval including the saturation temperature. The temperature interval may be 6 K or 5 K or 4 K or 3 K or 2 K.

The preheater assembly may comprise an electric heating device for heating the working fluid. In this way, for example, the time between starting up the system and reaching the optimum temperature of the working fluid upstream of the evaporator can be kept particularly short.

According to the invention the circuit further comprises a fourth circuit section for guiding a fourth portion of the working fluid from the at least one evaporator to a condenser. The second circuit section may be connected to the fourth circuit section. Upon exiting the evaporator, i.e. in the fourth circuit section, the working fluid has a comparatively large amount of thermal energy. This thermal energy can thus be used particularly advantageously to be fed to the preheater assembly by the provision of the connection between the fourth circuit section and the second circuit section.

Accordingly, the thermal energy that is "already in the system" can be used by the preheater assembly. The second circuit section can be used to branch off some of the thermal energy of the working fluid in the fourth circuit section and route it back to the preheater assembly, particularly in a controlled way, where it is mixed with a "main flow" in form of the flow of the first portion of the working fluid in the first circuit section to heat it up.

The circuit may further comprise a fifth circuit section for guiding a fifth portion of the working fluid from the condenser to the first circuit section, wherein the first portion of the working fluid originates from the fifth portion. In this way a closed circuit or closed loop for guiding the working fluid is provided.

The fifth circuit section may comprise a reservoir for the working fluid. The reservoir may be configured to balance the system, e. g. by storing excess working fluid and compensating for volume changes of the working fluid.

The system may further comprise a pump for pumping the working fluid through the two-phase working fluid circuit. The pump may be provided for example at the fifth circuit section, e. g. between the reservoir and the first circuit section.

The thermal characteristics may include temperature and/or pressure and/or thermal energy. The first thermal characteristics may comprise that the working fluid is in a liquid phase, the second thermal characteristics may comprise that the working fluid is partly in a liquid phase and partly in a gaseous phase, and the third thermal characteristics may comprise that the working fluid is in a liquid phase. The first thermal characteristics may be different from the third thermal characteristics. Specifically, the third thermal characteristics may comprise that the working fluid contains more energy compared to the first thermal characteristics.

The system may further comprise a valve disposed within the second circuit section. The valve makes it possible to influence an intensity of a flow (i. e. a volumetric flow rate) of the working fluid through the second circuit section. In this way it is possible to influence how much thermal energy is supplied to the preheater assembly via the working fluid flowing through the second circuit section. The valve may be a one way valve.

The valve may be configured to allow the working fluid to flow from the fourth circuit section via the second circuit section to the preheater assembly and further being configured to prevent the working fluid from flowing from the preheater assembly via the second circuit section to the fourth circuit section. In particular, this at least essentially prevents thermal energy from being extracted from the working fluid in the first circuit section before it subsequently enters the evaporator.

The valve may be configured to control a flow of the working fluid from the fourth circuit section via the second circuit section to the preheater assembly. In this way it is possible to quantitively determine the amount of thermal energy that is fed to the first portion of the working fluid, i. e. to the working fluid in the first circuit section.

The system may further comprise at least one temperature and/or pressure sensor device for measuring a temperature and/or a pressure of the working fluid. The at least one temperature and/or pressure sensor device may be disposed within the first circuit section and/or within the third circuit section. A temperature or pressure sensor may also or alternatively be provided in the second circuit section. A temperature or pressure value measured by the temperature and/or pressure sensor device can be particularly advantageously used for an improved control of the flow of the working fluid through the second circuit section.

To this end, for example the valve may be configured to be operated under use of a temperature and/or pressure information generated or measured by the temperature and/or pressure sensor device.

The preheater assembly may comprise a junction configured to allow the first portion of the working fluid to mix with the second portion of working fluid. In this way, a structurally simple and thus particularly reliable configuration for mixing of the first portion of the working fluid with the second portion of the working fluid is made possible.

The preheater assembly may further comprise a coupling circuit section connecting the junction to the third circuit section. The coupling circuit section may be for example tube-shaped.

The electric heating device of the preheater assembly - if provided - may be disposed at the coupling circuit section.

The preheater assembly may further comprise a heat exchanger connected to the first circuit section and to the second circuit section and being configured to exchange heat between the first portion of the working fluid and the second portion of the working fluid. The heat exchanger allows for an improved control of heat exchange between the working fluid originating from the first circuit section and the working fluid originating from the second circuit section. The heat exchanger may be configured to exchange heat between the first portion of the working fluid and the second portion of the working fluid without exchanging working fluid.

Particularly, the configuration may be such that the working fluid condenses in the heat exchanger and gives its thermal energy to the "main fluid" in form of the flow of the first portion of the working fluid in the first circuit section. Subsequently, the working fluid will be mixed with the "main flow" downstream of the heat exchanger.

The system may further comprise an extension circuit section for guiding the working fluid originating from the second circuit section, after it has passed through the heat exchanger, to a coupling circuit section connecting the first circuit section to the third circuit section.

The system may further comprise an auxiliary pump for pumping the working fluid from the extension circuit section to the third circuit section. The auxiliary pump is needed depending on the system design and pressure level. The auxiliary pump, however, needs much less energy compared to a preheater according to prior art as described above.

The preheater assembly may further comprise a heat exchanger connected to the second circuit section and to a coupling circuit section connecting the first circuit section to the third circuit section. The heat exchanger may be configured to exchange heat between the working fluid originating from the second circuit section and the working fluid within the coupling circuit section.

Here, the working fluid is mixed with the "main flow" upstream of the heat exchanger.

The system may further comprise an extension circuit section for guiding the working fluid originating from the second circuit section, after it has passed through the heat exchanger, to the coupling circuit section at a point between the first circuit section and the heat exchanger. The point may be between the first circuit section and the pump or between the pump and the preheater assembly.

Alternatively, the extension circuit section may be configured to guide the working fluid originating from the second circuit section, after it has passed through the heat exchanger, to the reservoir.

The system may further comprise an auxiliary pump for pumping the working fluid from the extension circuit section to the coupling circuit section or to the reservoir.

According to an alternative or additional aspect of the present invention, a pumped two-phase cooling system is provided that comprises a reservoir, containing a two-phase working fluid, an evaporator, a condenser, a two-phase working fluid circuit connecting the reservoir, the evaporator and to the condenser and configured to allow the working fluid to flow through the evaporator and through the condenser. The system further comprises a pump, configured to pump the working fluid through the circuit, and a preheater assembly, disposed and configured to preheat the working fluid before entering the evaporator. The circuit comprises a first circuit part configured to allow the working fluid to flow from the evaporator to the condenser, a second circuit part configured to allow the working fluid to flow from the condenser to the evaporator, and a third circuit part connecting the first circuit part to the second circuit part, bypassing the condenser.

### SHORT DESCRIPTION OF THE DRAWINGS

The subject-matter of the invention will be explained in more detail with reference to preferred exemplary embodiments which are illustrated in the attached drawings.
Fig. 1 is a schematic illustration of a pumped two-phase cooling system according to prior art.
Fig. 2 is a schematic illustration of a pumped two-phase cooling system according to a first embodiment.
Fig. 3 is a schematic illustration of a pumped two-phase cooling system according to a second embodiment.
Fig. 4 is a schematic illustration of a pumped two-phase cooling system according to a third embodiment.

### DETAILED DESCRIPTION

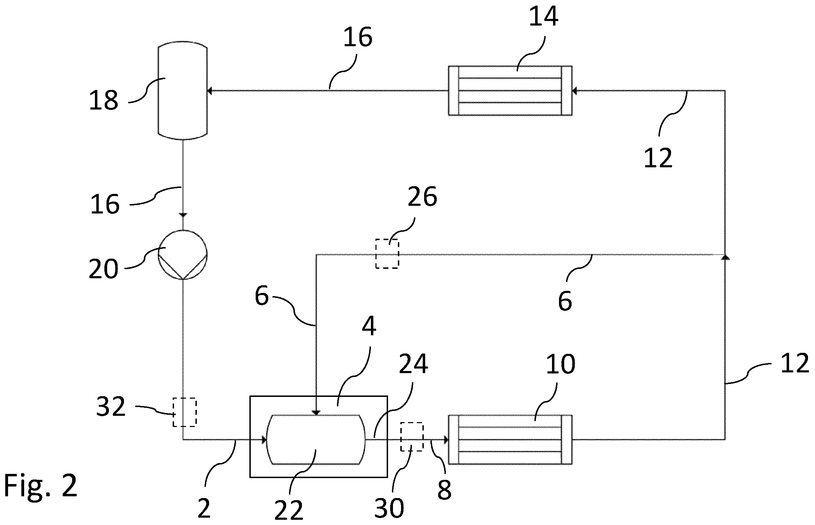

Fig. 2 is a schematic illustration of a pumped two-phase cooling system according to a first embodiment. The cooling system comprises a two-phase working fluid circuit for guiding a two-phase working fluid.

The system further comprises a pump 20, a preheater assembly 4, an evaporator 10, and a condenser 14. The pump 20 is configured to pump the working fluid through the circuit. Specifically, the system is configured such that the working fluid can be pumped by the pump 20 via the circuit through the evaporator 10 and through the condenser 14.

The system illustrated in Fig. 2 shows an example system having only one evaporator 10. However, the system may comprise a plurality of evaporators. These evaporators may, for example, be connected in series or in parallel.

Further, the system comprises a reservoir 18 for balancing the system.

The circuit comprises a first circuit section 2, a second circuit section 6, and a third circuit section 8. The first circuit section 2 is configured to guide a first portion of the working fluid to the preheater assembly 4. The second circuit section 6 is configured to guide a second portion of the working fluid to the preheater assembly 4. The third circuit section 8 is configured to guide a third portion of the working fluid from the preheater assembly 4 to the evaporator 10.

The first portion of the working fluid has first thermal characteristics comprising that the working fluid is in a liquid phase. The second portion of the working fluid has second thermal characteristics comprising that the working fluid is partly in a liquid phase and partly in a gaseous phase. The third portion of the working fluid has third thermal characteristics comprising that the working fluid is in a liquid phase.

The third thermal characteristics are based on the first and second thermal characteristics.

The preheater assembly 4 comprises a junction 22 configured to allow the first portion of the working fluid to mix with the second portion of the working fluid. In other words, the working fluid originating from the first circuit section 2 and the working fluid originating from the second circuit section 6 are mixed at the junction 22 within the preheater assembly 4. Consequently, the thermal energy of the working fluid leaving the preheater assembly 4, i. e. the third portion of the working fluid is based on or depends on the first thermal characteristics and the second thermal characteristics. The third thermal characteristics further depends on a first volumetric flow rate at which the first portion of the working fluid reaches the junction 22 and a second volumetric flow rate at which the second portion of the working fluid reaches the junction 22.

The preheater assembly 4 further comprises a coupling circuit section 24 that connects the junction 22 to the third circuit section 8 so that the working fluid can flow from the junction 22 into the third circuit section 8 via the coupling circuit section 24.

The preheater assembly 4 is configured to heat the working fluid to its saturation temperature or at least nearly to its saturation temperature.

The circuit further comprises a fourth circuit section 12 for guiding a fourth portion of the working fluid from the evaporator 10 to the condenser 14. In other words, the fourth circuit section 12 connects the evaporator 10 with the condenser 14 such that the working fluid can flow from the evaporator 10 to the condenser 14.

The second circuit section 6 is connected to the fourth circuit section 12. In other words, one end of the second circuit section 6 enters the preheater assembly 4 and the other, opposite end of the second circuit section 6 is fluidly connected to the fourth circuit section 12.

The circuit further comprises a fifth circuit section 16 for guiding a fifth portion of the working fluid from the condenser 14 to the first circuit section 2. In other words, the fifth circuit section 16 connects the condenser 14 with the first circuit section 2 such that the working fluid can flow from the condenser 14 to the first circuit section 2.

The reservoir 18 and/or the pump 20 may be disposed within the fifth circuit section 16, as exemplarily sketched in Fig. 2.

The preheater assembly 4 may comprise an electric heating device for heating the working fluid. The heating device may be disposed and arranged to heat the working fluid within the coupling circuit section 24, i. e. between the junction 22 and the evaporator 10. In this way, the working fluid can be heated by the electric heating device up to its or at least nearly to its saturation temperature if the working fluid downstream of the junction 22 does not yet have the desired temperature for entering the evaporator 10. This can be particularly advantageous during an initial phase after the system has been started up, as long as an average temperature of the working fluid is not yet at an equilibrium level.

The system may further comprise a valve 26 disposed within the second circuit section 6. The valve 26 may be configured to allow the working fluid to flow from the fourth circuit section 12 via the second circuit section 6 to the preheater assembly 4. The valve 26 may be configured to prevent the working fluid from flowing from the preheater assembly 4 via the second circuit section 6 to the fourth circuit section 12.

The valve 26 may further be configured to control a flow, i. e. a volumetric flow rate of the working fluid from the fourth circuit section 12 via the second circuit section 6 to the preheater assembly 4. In this way, an amount of thermal energy fed to the preheater assembly 4 by the working fluid within the second circuit section 6 can be adjusted.

The system may further comprise at least one temperature and/or pressure sensor device 30, 32 for measuring a temperature and/or a pressure of the working fluid. The at least one temperature and/or pressure sensor device 30, 32 may be disposed for example within the first circuit section 2 and/or within the third circuit section 8. A temperature or pressure measured by the temperature and/or pressure sensor device 30, 32 can be advantageously used for an improved control of the thermal characteristics of the working fluid.

Particularly, the valve 26 may be configured to be operated under use of a temperature and/or pressure information generated by the temperature and/or pressure sensor device 30, 32.

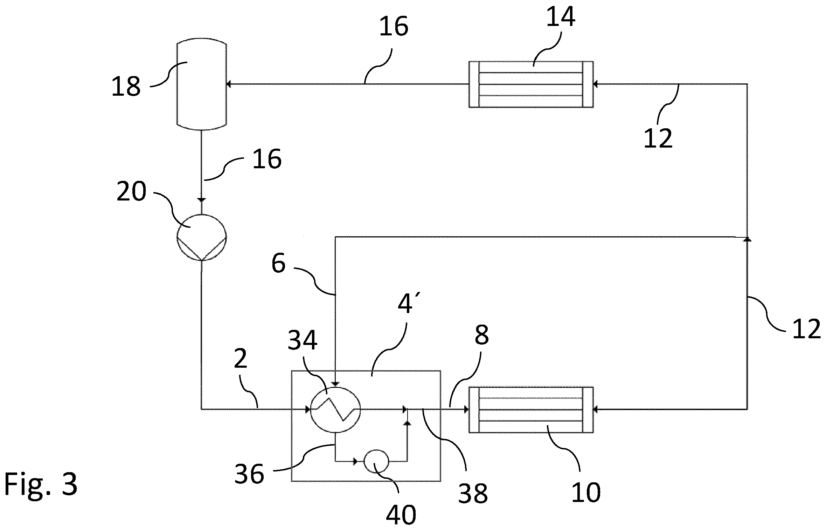

Fig. 3 is a schematic illustration of a pumped two-phase cooling system according to a second embodiment.

Unless otherwise stated below, the above description of the first embodiment also applies to the other embodiments. The reference signs are used in an analogous manner.

The preheater assembly 4' according to the second embodiment comprises a heat exchanger 34 connected to the first circuit section 2 and to the second circuit section 6. The preheater assembly 34 is configured to exchange heat between the first portion of the working fluid and the second portion of the working fluid. The system further comprises an extension circuit section 36 for guiding the working fluid originating from the second circuit section 6, after it has passed through the heat exchanger 34, to a coupling circuit section 38 connecting the first circuit section 2 to the third circuit section 8.

Further, the system comprises an auxiliary pump 40 for pumping the working fluid from the extension circuit section 36 to the third circuit section 8.

The auxiliary pump 40 may be configured to be operated only when required. Due to the arrangement of the second circuit section 6 and the extension circuit section 36, it can be assumed that the auxiliary pump 40 in principle requires less energy compared to a corresponding pump according to prior art as described above.

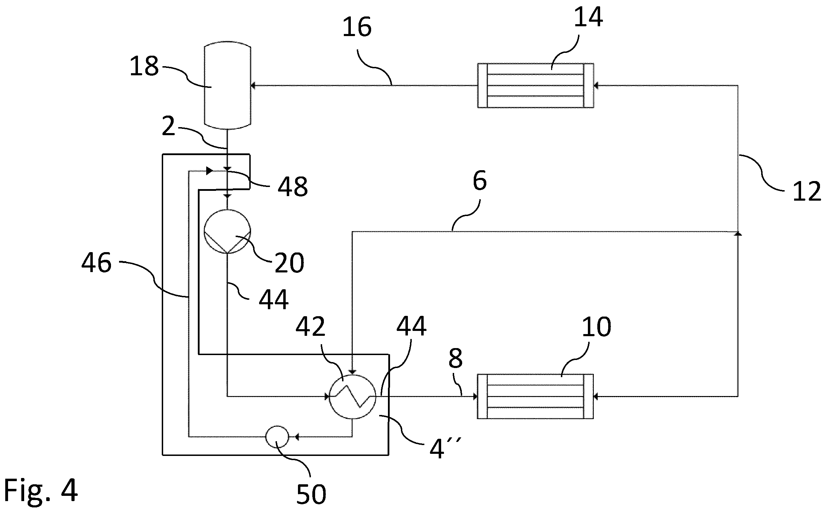

Fig. 4 is a schematic illustration of a pumped two-phase cooling system according to a third embodiment.

The preheater assembly 4" according to the third embodiment comprises a heat exchanger 42 connected to the second circuit section 6 and to a coupling circuit section 44 connecting the first circuit section 2 to the third circuit section 8. The heat exchanger 42 is configured to exchange heat between the working fluid originating from the second circuit section 6 and the working fluid within the coupling circuit section 44.

The system further comprises an extension circuit section 46 for guiding the working fluid originating from the second circuit section 6, after it has passed through the heat exchanger 42, to the coupling circuit section 44 at a point 48 between the first circuit section 2 and the heat exchanger 42. The point 48 may be for example between the first circuit section 2 and the pump 2 or for example between the pump 20 and the heat exchanger 42. Alternatively, the extension circuit section may be configured to guide the working fluid originating from the second circuit section 6, after it has passed through the heat exchanger 42, to the reservoir 18.

The system further comprises an auxiliary pump 50 for pumping the working fluid from the extension circuit section 46 to the coupling circuit section 44 or to the reservoir 18. The auxiliary pump 50 may be configured to be operated only when required. Due to the arrangement of the second circuit section 6 and the extension circuit section 46, it can be assumed that the auxiliary pump 40 in principle requires less energy compared to a corresponding pump according to prior art as described above.

While the present invention has been described in detail in the drawings and forgoing description, such description is to be considered illustrative or exemplary and not restrictive. Variations to the disclosed embodiments can be understood and effected by those skilled in the art and practicing the claimed subject-matter, from a study of the drawings, the disclosure, and the appended claims. In the claims, the word "comprising" does not exclude other elements, and the indefinite article "a" or "an" does not exclude a plurality. The mere fact that certain elements or steps are recited in distinct claims does not indicate that a combination of these elements or steps cannot be used to advantage, specifically, in addition to the actual claim dependency, any further meaningful claim combination shall be considered disclosed.

## Claims

1. Pumped two-phase cooling system, comprising
a two-phase working fluid circuit, having
a first circuit section (2) for guiding a first portion of the working fluid to a preheater assembly (4, 4', 4"), the first portion in the first circuit section (2) having first thermal characteristics,
a second circuit section (6) for guiding a second portion of the working fluid to the preheater assembly (4), the second portion in the second circuit section (6) having second thermal characteristics, and
a third circuit section (8) for guiding a third portion of the working fluid from the preheater assembly (4) to at least one evaporator (10), the third portion in the third circuit section (8) having third thermal characteristics based on the first and second thermal characteristics, **characterized in that** the two-phase working fluid circuit further comprises
a fourth circuit section (12) for guiding a fourth portion of the working fluid from the at least one evaporator (10) to a condenser (14), the second circuit section (6) being connected to the fourth circuit section (12), wherein one end of the second circuit section (6) enters the preheater assembly (4) and the other, opposite end of the second circuit section (6) is fluidly connected to the fourth circuit section (12).

2. Pumped two-phase cooling system of claim 1, the two-phase working fluid circuit further comprising a fifth circuit section (16) for guiding a fifth portion of the working fluid from the condenser (14) to the first circuit section (2), wherein the first portion of the working fluid originates from the fifth portion.

3. Pumped two-phase cooling system of claim 2, the fifth circuit section (16) comprising a reservoir (18) for the working fluid.

4. Pumped two-phase cooling system of any of the preceding claims, further comprising a pump (20) for pumping the working fluid through the two-phase working fluid circuit.

5. Pumped two-phase cooling system of any of the preceding claims, further comprising a valve (26), preferably a one way valve, disposed within the second circuit section (6).

6. Pumped two-phase cooling system of claim 5, the valve (26) being configured to allow the working fluid to flow from the fourth circuit section (12) via the second circuit section (6) to the preheater assembly (4) and further being configured to prevent the working fluid from flowing from the preheater assembly (4, 4', 4") via the second circuit section (6) to the fourth circuit section (12).

7. Pumped two-phase cooling system of claims 5 or 6, the valve (26) being configured to control a flow of the working fluid from the fourth circuit section (12) via the second circuit section (6) to the preheater assembly (4, 4', 4").

8. Pumped two-phase cooling system of any of the preceding claims, further comprising at least one temperature and/or pressure sensor device (30, 32) for measuring a temperature and/or a pressure of the working fluid, the at least one temperature and/or pressure sensor device (30, 32) being disposed within the first circuit section (2) and/or within the third circuit section (8).

9. Pumped two-phase cooling system of any of the preceding claims, comprising the features of claims 5 and 8, wherein the valve (26) is configured to be operated under use of a temperature and/or pressure information generated by the temperature and/or pressure sensor device (30, 32).

10. Pumped two-phase cooling system of any of the preceding claims, the preheater assembly (4) comprising a junction (22) configured to allow the first portion of the working fluid to mix with the second portion of working fluid.

11. Pumped two-phase cooling system of any of claims 1 to 9, the preheater assembly (4') further comprising a heat exchanger (34) connected to the first circuit section (2) and to the second circuit section (6) and being configured to exchange heat between the first portion of the working fluid and the second portion of the working fluid,
the system further comprising an extension circuit section (36) for guiding the working fluid originating from the second circuit section (6), after it has passed through the heat exchanger (34), to a coupling circuit section (38) connecting the first circuit section (2) to the third circuit section (8).

12. Pumped two-phase cooling system of claim 11, further comprising an auxiliary pump (40) for pumping the working fluid from the extension circuit section (36) to the third circuit section (8).

13. Pumped two-phase cooling system of any of aspects 1 to 9, the preheater assembly (4") further comprising a heat exchanger (42) connected to the second circuit section (6) and to a coupling circuit section (44) connecting the first circuit section (2) to the third circuit section (8), the heat exchanger (42) being configured to exchange heat between the working fluid originating from the second circuit section (6) and the working fluid within the coupling circuit section (44),
the system further comprising an extension circuit section (46) for guiding the working fluid originating from the second circuit section (6), after it has passed through the heat exchanger (42), to the coupling circuit section (44) at a point (48) between the first circuit section (2) and the heat exchanger (42).

14. Pumped two-phase cooling system of claim 13, further comprising an auxiliary pump (50) for pumping the working fluid from the extension circuit section (46) to the coupling circuit section (44).

## Patentansprüche

1. Zwei-Phasen-Kühlsystem mit Pumpe, aufweisend einen Zweiphasen-Arbeitsfluidkreislauf mit
einem ersten Kreislaufabschnitt (2) zum Führen eines ersten Teils des Arbeitsfluids zu einer Vorwärmeranordnung (4, 4', 4"), wobei der erste Teil in dem ersten Kreislaufabschnitt (2) erste thermische Eigenschaften aufweist,
einem zweiten Kreislaufabschnitt (6) zum Führen eines zweiten Teils des Arbeitsfluids zur Vorwärmeranordnung (4), wobei der zweite Teil in dem zweiten Kreislaufabschnitt (6) zweite thermische Eigenschaften aufweist, und
einem dritten Kreislaufabschnitt (8) zum Führen eines dritten Teils des Arbeitsfluids von der Vorwärmeranordnung (4) zu mindestens einem Verdampfer (10), wobei der dritte Teil in dem dritten Kreislaufabschnitt (8) dritte thermische Eigenschaften basierend auf den ersten und zweiten thermischen Eigenschaften aufweist, **dadurch gekennzeichnet, dass** der Zweiphasen-Arbeitsfluidkreislauf ferner
einen vierten Kreislaufabschnitt (12) zum Führen eines vierten Teils des Arbeitsfluids vom mindestens einen Verdampfer (10) zu einem Kondensator (14) aufweist, wobei der zweite Kreislaufabschnitt (6) mit dem vierten Kreislaufabschnitt (12) verbunden ist, wobei ein Ende des zweiten Kreislaufabschnitts (6) in die Vorwärmeranordnung (4) eintritt und das andere, gegenüberliegende Ende des zweiten Kreislaufabschnitts (6) mit dem vierten Kreislaufabschnitt (12) in Fluidverbindung steht.

2. Zwei-Phasen-Kühlsystem mit Pumpe nach Anspruch 1, wobei der Zweiphasen-Arbeitsfluidkreislauf ferner einen fünften Kreislaufabschnitt (16) zum Führen eines fünften Teils des Arbeitsfluids vom Kondensator (14) zum ersten Kreislaufabschnitt (2) aufweist, wobei der erste Teil des Arbeitsfluids vom fünften Teil stammt.

3. Zwei-Phasen-Kühlsystem mit Pumpe nach Anspruch 2, wobei der fünfte Kreislaufabschnitt (16) einen Behälter (18) für das Arbeitsfluid aufweist.

4. Zwei-Phasen-Kühlsystem mit Pumpe nach einem der vorhergehenden Ansprüche, ferner aufweisend eine Pumpe (20) zum Pumpen des Arbeitsfluids durch den Zweiphasen-Arbeitsfluidkreislauf.

5. Zwei-Phasen-Kühlsystem mit Pumpe nach einem der vorhergehenden Ansprüche, ferner aufweisend ein Ventil (26), vorzugsweise ein Einwegventil, das innerhalb des zweiten Kreislaufabschnitts (6) angeordnet ist.

6. Zwei-Phasen-Kühlsystem mit Pumpe nach Anspruch 5, wobei das Ventil (26) dazu ausgelegt ist, zuzulassen, dass das Arbeitsfluid vom vierten Kreislaufabschnitt (12) über den zweiten Kreislaufabschnitt (6) zur Vorwärmeranordnung (4) strömt, und ferner dazu ausgelegt ist, zu verhindern, dass das Arbeitsfluid von der Vorwärmeranordnung (4, 4', 4") über den zweiten Kreislaufabschnitt (6) zum vierten Kreislaufabschnitt (12) strömt.

7. Zwei-Phasen-Kühlsystem mit Pumpe nach Anspruch 5 oder 6, wobei das Ventil (26) dazu ausgelegt ist, einen Fluss des Arbeitsfluids vom vierten Kreislaufabschnitt (12) über den zweiten Kreislaufabschnitt (6) zur Vorwärmeranordnung (4, 4', 4") zu steuern.

8. Zwei-Phasen-Kühlsystem mit Pumpe nach einem der vorhergehenden Ansprüche, ferner aufweisend mindestens eine Temperatur- und/oder Drucksensorvorrichtung (30, 32) zum Messen einer Temperatur und/oder eines Drucks des Arbeitsfluids, wobei die mindestens eine Temperatur-und/oder Drucksensorvorrichtung (30, 32) innerhalb des ersten Kreislaufabschnitts (2) und/oder innerhalb des dritten Kreislaufabschnitts (8) angeordnet ist.

9. Zwei-Phasen-Kühlsystem mit Pumpe nach einem der vorhergehenden Ansprüche, aufweisend die Merkmale der Ansprüche 5 und 8, wobei das Ventil (26) dazu ausgelegt ist, unter Verwendung einer Temperatur- und/oder Druckinformation betrieben zu werden, die durch die Temperatur- und/oder Drucksensorvorrichtung (30, 32) erzeugt wird.

10. Zwei-Phasen-Kühlsystem mit Pumpe nach einem der vorhergehenden Ansprüche, wobei die Vorwärmeranordnung (4) eine Verbindungsstelle (22) aufweist, die dazu ausgelegt ist, dem ersten Teil des Arbeitsfluids zu ermöglichen, sich mit dem zweiten Teil des Arbeitsfluids zu mischen.

11. Zwei-Phasen-Kühlsystem mit Pumpe nach einem der Ansprüche 1 bis 9, wobei die Vorwärmeranordnung (4') ferner einen Wärmetauscher (34) aufweist, der mit dem ersten Kreislaufabschnitt (2) und dem zweiten Kreislaufabschnitt (6) verbunden ist und dazu ausgelegt ist, Wärme zwischen dem ersten Teil des Arbeitsfluids und dem zweiten Teil des Arbeitsfluids auszutauschen,
wobei das System ferner einen Verlängerungskreislaufabschnitt (36) zum Führen des Arbeitsfluids, das vom zweiten Kreislaufabschnitt (6) stammt, nachdem es den Wärmetauscher (34) durchströmt hat, zu einem Kopplungskreislaufabschnitt (38) aufweist, der den ersten Kreislaufabschnitt (2) mit dem dritten Kreislaufabschnitt (8) verbindet.

12. Zwei-Phasen-Kühlsystem mit Pumpe nach Anspruch 11, ferner aufweisend eine Hilfspumpe (40) zum Pumpen des Arbeitsfluids vom Verlängerungskreislaufabschnitt (36) zu dem dritten Kreislaufabschnitt (8).

13. Zwei-Phasen-Kühlsystem mit Pumpe nach einem der Aspekte 1 bis 9, wobei die Vorwärmeranordnung (4") ferner einen Wärmetauscher (42) aufweist, der mit dem zweiten Kreislaufabschnitt (6) und mit einem Kopplungskreislaufabschnitt (44) verbunden ist, der den ersten Kreislaufabschnitt (2) mit dem dritten Kreislaufabschnitt (8) verbindet, wobei der Wärmetauscher (42) dazu ausgelegt ist, Wärme zwischen dem Arbeitsfluid, das vom zweiten Kreislaufabschnitt (6) stammt, und dem Arbeitsfluid innerhalb des Kopplungskreislaufabschnitts (44) auszutauschen,
wobei das System ferner einen Verlängerungskreislaufabschnitt (46) zum Führen des vom zweiten Kreislaufabschnitt (6) stammenden Arbeitsfluids, nachdem es den Wärmetauscher (42) durchströmt hat, zum Kopplungskreislaufabschnitt (44) an einer Stelle (48) zwischen dem ersten Kreislaufabschnitt (2) und dem Wärmetauscher (42) aufweist.

14. Zwei-Phasen-Kühlsystem mit Pumpe nach Anspruch 13, ferner aufweisend eine Hilfspumpe (50) zum Pumpen des Arbeitsfluids vom Verlängerungskreislaufabschnitt (46) zum Kopplungskreislaufabschnitt (44).

## Revendications

1. Système de refroidissement biphasique à pompe, comprenant
un circuit de fluide de travail biphasique, comportant une première section de circuit (2) pour guider une première partie du fluide de travail vers un ensemble de préchauffage (4, 4', 4"), la première partie dans la première section de circuit (2) présentant des premières caractéristiques thermiques,
une deuxième section de circuit (6) pour guider une deuxième partie du fluide de travail vers l'ensemble de préchauffage (4), la deuxième partie de la deuxième section de circuit (6) présentant des deuxièmes caractéristiques thermiques, et
une troisième section de circuit (8) pour guider une troisième partie du fluide de travail de l'ensemble de préchauffage (4) jusqu'à au moins un évaporateur (10), la troisième partie de la troisième section de circuit (8) présentant des troisièmes caractéristiques thermiques basées sur les premières et deuxièmes caractéristiques thermiques, **caractérisé en ce que** le circuit de fluide de travail biphasique comprend en outre une quatrième section de circuit (12) pour guider une quatrième partie du fluide de travail de l'au moins un évaporateur (10) jusqu'à un condenseur (14), la deuxième section de circuit (6) étant connectée à la quatrième section de circuit (12), une extrémité de la deuxième section de circuit (6) entrant dans l'ensemble de préchauffage (4) et l'autre extrémité, opposée, de la deuxième section de circuit (6) étant connectée fluidiquement à la quatrième section de circuit (12).

2. Système de refroidissement biphasique à pompe selon la revendication 1, le circuit de fluide de travail biphasique comprenant en outre une cinquième section de circuit (16) pour guider une cinquième partie du fluide de travail du condenseur (14) jusqu'à la première section de circuit (2), la première partie du fluide de travail provenant de la cinquième partie.

3. Système de refroidissement biphasique à pompe selon la revendication 2, la cinquième section de circuit (16) comprenant un réservoir (18) pour le fluide de travail.

4. Système de refroidissement biphasique à pompe selon l'une quelconque des revendications précédentes, comprenant en outre une pompe (20) pour pomper le fluide de travail à travers le circuit de fluide de travail biphasique.

5. Système de refroidissement biphasique à pompe selon l'une quelconque des revendications précédentes, comprenant en outre une vanne (26), de préférence une vanne unidirectionnelle, disposée à l'intérieur de la deuxième section de circuit (6).

6. Système de refroidissement biphasique à pompe selon la revendication 5, la vanne (26) étant configurée pour permettre au fluide de travail de s'écouler de la quatrième section de circuit (12) via la deuxième section de circuit (6) jusqu'à l'ensemble de préchauffage (4) et étant en outre configurée pour empêcher le fluide de travail de s'écouler de l'ensemble de préchauffage (4, 4', 4") via la deuxième section de circuit (6) jusqu'à la quatrième section de circuit (12).

7. Système de refroidissement biphasique à pompe selon la revendication 5 ou 6, la vanne (26) étant configurée pour commander un écoulement du fluide de travail de la quatrième section de circuit (12) via la deuxième section de circuit (6) jusqu'à l'ensemble de préchauffage (4, 4', 4").

8. Système de refroidissement biphasique à pompe selon l'une quelconque des revendications précédentes, comprenant en outre au moins un dispositif capteur de température et/ou de pression (30, 32) pour mesurer une température et/ou une pression du fluide de travail, l'au moins un dispositif capteur de température et/ou de pression (30, 32) étant disposé à l'intérieur de la première section de circuit (2) et/ou à l'intérieur de la troisième section de circuit (8).

9. Système de refroidissement biphasique à pompe selon l'une quelconque des revendications précédentes, comprenant les caractéristiques des revendications 5 et 8, dans lequel la soupape (26) est configurée pour fonctionner en utilisant une information de température et/ou de pression générée par le dispositif capteur de température et/ou de pression (30, 32).

10. Système de refroidissement biphasique à pompe selon l'une quelconque des revendications précédentes, l'ensemble de préchauffage (4) comprenant une jonction (22) configurée pour permettre à la première partie du fluide de travail de se mélanger avec la deuxième partie du fluide de travail.

11. Système de refroidissement biphasique à pompe selon l'une quelconque des revendications 1 à 9, l'ensemble de préchauffage (4') comprenant en outre un échangeur de chaleur (34) relié à la première section de circuit (2) et à la deuxième section de circuit (6) et étant configuré pour échanger de la chaleur entre la première partie du fluide de travail et la deuxième partie du fluide de travail,
le système comprenant en outre une section de circuit d'extension (36) pour guider le fluide de travail provenant de la deuxième section de circuit (6), après son passage dans l'échangeur de chaleur (34), jusqu'à une section de circuit de couplage (38) reliant la première section de circuit (2) à la troisième section de circuit (8).

12. Système de refroidissement biphasique à pompe selon la revendication 11, comprenant en outre une pompe auxiliaire (40) pour pomper le fluide de travail de la section de circuit d'extension (36) jusqu'à la troisième section de circuit (8).

13. Système de refroidissement biphasique à pompe selon l'un quelconque des aspects 1 à 9, l'ensemble de préchauffage (4") comprenant en outre un échangeur de chaleur (42) relié à la deuxième section de circuit (6) et à une section de circuit de couplage (44) reliant la première section de circuit (2) à la troisième section de circuit (8), l'échangeur de chaleur (42) étant configuré pour échanger de la chaleur entre le fluide de travail provenant de la deuxième section de circuit (6) et le fluide de travail au sein de la section de circuit de couplage (44),
le système comprenant en outre une section de circuit d'extension (46) pour guider le fluide de travail provenant de la deuxième section de circuit (6), après son passage à travers l'échangeur de chaleur (42), jusqu'à la section de circuit de couplage (44) en un point (48) entre la première section de circuit (2) et l'échangeur de chaleur (42).

14. Système de refroidissement biphasique à pompe selon la revendication 13, comprenant en outre une pompe auxiliaire (50) pour pomper le fluide de travail de la section de circuit d'extension (46) jusqu'à la section de circuit de couplage (44).
